# EUROPEAN PATENT SPECIFICATION

(11) **EP 0 762 374 B1**
(45) Date of publication and mention of the grant of the patent: **04.04.2007**
(21) Application number: 96111992.2
(22) Date of filing: 25.07.1996
(51) Int. Cl.: G09G 3/32, G09G 3/30

(54) **Active driven led matrices**
Aktive Steuerung für Anzeigetafeln mit Leuchtdioden
Commande active pour matrices de diodes électroluminescentes

(30) Priority: 21.08.1995 US 517222
(43) Date of publication of application: 12.03.1997
(73) Proprietor: MOTOROLA, INC., Schaumburg, IL 60196 (US)
(72) Inventor: Shieh, Chan-Long, Paradise Valley, Arizona 85253 (US); Lee, Hsing-Chung, Calabasas, California 91302 (US); So, Franky, Tempe, Arizona 85284 (US)
(74) Representative: Cross, Rupert Edward Blount

(56) References cited:
- DE-A- 4 240 554
- US-A- 5 019 807
- US-A- 5 134 387
- US-A- 5 386 179
- 1988 INTERNATIONAL DISPLAY RESEARCH CONFERENCE, 4 - 6 October 1988, SAN DIEGO, CA. U.S.A., pages 74-79, XP000092435 VANFLETEREN ET AL.: "Active matrix CdSe TFT addressed electroluminescent displays"

## Description

### Field of the Invention

The present invention pertains to active matrices and more specifically to new apparatus and methods of driving active matrices.

### Background of the Invention

Displays utilizing two dimensional arrays, or matrices, of pixels each containing one or more light emitting devices are very popular in the electronics field and especially in portable electronic and communication devices, because large amounts of data and pictures can be transmitted very rapidly and to virtually any location. One problem with these matrices is that each row (or column) of light emitting devices in the matrix must be separately addressed and driven with a video or data driver.

US 5386179 A1 (SATO) describes means for current switching within electroluminescent devices arranged in rows and columns by supplying scan and image data, the image data activating signal determining when a pixel is activated.

Generally, in non-color type displays (black and white) each pixel contains a single light emitting device which must be driven in a range of values to achieve a range of gray (gray scale) between full on (white) and full off (black). In order to get good gray scale, the data drivers generally have to be able to deliver an accurate analog voltage to each pixel. However, analog driver circuits are very expensive and, since there must be hundreds of data drivers (one for each column of light emitting devices), are the major part of the display cost.

Further, in full color displays, each pixel contains at least three light emitting devices, each of which produces a different color (e.g. red, green and blue) and each of which must be driven (generally a row at a time) in a range of values to achieve a range of that specific color between full on and full off. Thus, full color displays contain three times as many analog drivers, which triples the manufacturing cost of the display. Also, the additional analog drivers require additional space and power, which can be a problem in portable electronic devices, such as pagers, cellular and regular telephones, radios, data banks, etc.

Accordingly, it would be advantageous to be able to manufacture displays, and especially color displays, with simpler and fewer data drivers.

It is a purpose of the present invention to provide new and improved active driven matrices of light emitting device.

It is another purpose of the present invention to provide new and improved active driven matrices of light emitting device using digital data drivers.

It is still another purpose of the present invention to provide new and improved active driven matrices of light emitting device for color displays utilizing fewer data drivers.

It is a further purpose of the present invention to provide less expensive and smaller displays.

It is a still further purpose of the present invention to provide organic light emitting diode displays which are less expensive, smaller and easier to manufacture.

### Summary of the Invention

The above problems and others are at least partially solved and the above purposes and others are realized in a matrix of light emitting devices as set out in the attached independent claims. Preferable embodiments are set out in the attached dependent claims.

### Brief Description of the Drawings

Referring to the drawings:
FIG. 1 illustrates a block/schematic diagram of an active driven LED matrix embodying the present invention;
FIG. 2 illustrates a voltage waveform of the structure of FIG. 1;
FIG. 3 illustrates a block/schematic diagram of another active driven LED matrix embodying the present invention; and
FIGS. 4 and 5 illustrate voltage waveforms of the structure of FIG. 3.

### Description of the Preferred Embodiments

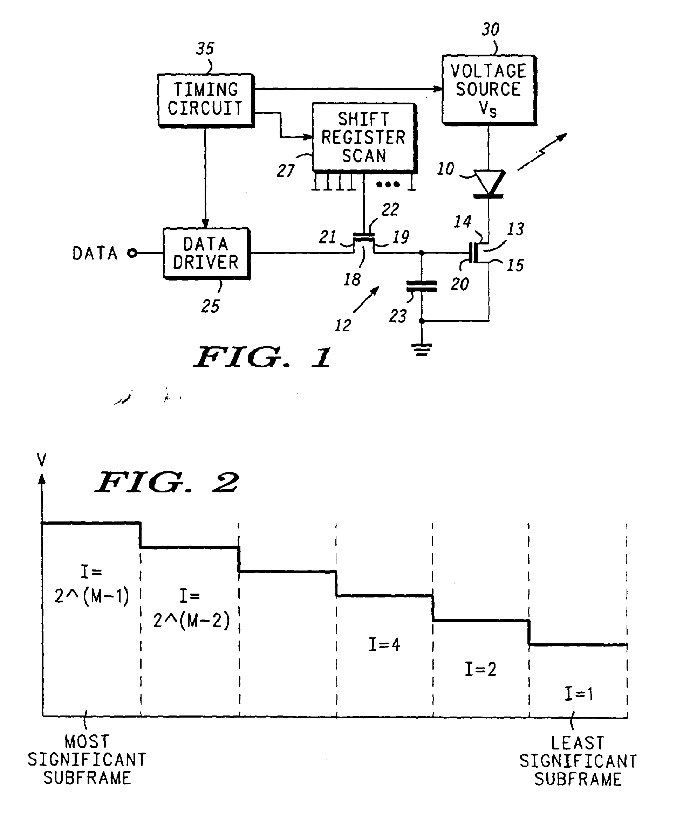

Referring now to FIG. 1, a simplified block/schematic drawing is illustrated showing an active driven light emitting diode matrix. For simplicity of this description, a single light emitting diode 10 is illustrated but it will be understood that diode 10 is simply one diode in a two dimensional array including rows and columns of light emitting diodes. Further, light emitting diode 10, and each other diode in the matrix has a semiconductor switch 12 attached thereto, making the matrix an active matrix. In this specific embodiment switch 12 includes a first transistor 13 having a current carrying electrode 14 connected to the cathode of diode 10 and a current carrying electrode 15 connected to a common return, such as ground or the like. Switch 12 further includes a second transistor 18 having a current carrying terminal 19 connected to a gate or control terminal 20 of transistor 13. A second current carrying terminal 21 of transistor 18 serves as a data input and a gate or control terminal 22 serves as an input for scan signals. A capacitor 23 is connected between control terminal 20 and the common return or ground as a storage element to maintain diode 10 in an ON mode for a specific period of time after switching. In this specific embodiment light emitting diode 10 and switch 12 form a pixel.

In this preferred embodiment, light emitting diode 10 is an organic light emitting diode, which is a current driven device, so that switch 12 is a low operating voltage device. Light emitting diode 10 is addressed by supplying a scan signal to control terminal 22 of transistor 18 and a data signal to current terminal 21. Depending upon the data signal, when transistor 13 is activated a current path is completed between the cathode of light emitting diode 10 and the common return, or ground. Each current carrying terminal 21 for each switch 12 in each pixel in a column are connected together and to a data driver 25. While transistors 13 and 18 are illustrated as n-type devices, it will be understood by those skilled in the art that diodes 10 could be reversed and p-type devices could be used in switch 12, if desired.

As an example, in a typical matrix there may be 640 columns by 480 rows of pixels. Thus, there are 640 data drivers 25. It will of course be understood that the matrix could be rotated ninety degrees so that the scan signals and data signals are supplied to columns and rows, respectively, if desired. Further, data drivers 25 are relatively simple digital drivers in this embodiment, for reasons that will become apparent presently. Data is supplied to a data input of each data driver 25, which data may be, for example, received from a wireless communication or from some data bank or storage device and may represent alpha-numeric and/or graphic information.

Control terminal 22 of each switch 12 in a row of pixels are connected together and to a circuit for supplying scan signals thereto. In the structure of FIG. 1, for purposes of this explanation, a shift register 27 is provided to supply the scan signals. Shift register 27 has a separate output for each row in the matrix (e.g. 480 outputs) and sequentially supplies a scan signal on each output in turn. Thus rows 1 through 480 of the matrix are sequentially supplied with a scan signal. As is understood in the art, a scan signal is applied to each row for a sufficient time to allow all of the data drivers to be activated so that each pixel in the row being scanned is addressed. A scan signal is then applied to the next row and all of the data drivers are activated, etc. Therefore, each pixel in the matrix is addressed with a scan and data signal by the combination of data drivers 25 and shift register 27.

A voltage source 30 is provided which is constructed to repetitiously supply a multi-step voltage waveform at an output thereof. A typical multi-step voltage waveform is illustrated in FIG. 2, including m ascending steps, or subframes, and each step represents the amount of voltage required to produce the intensity, I, produced by a specific light emitting diode (e.g. diode 10). All of the anodes of the light emitting diodes are connected together and to the output terminal of voltage source 30. In the operation, a first step of voltage (e.g. I=1) is applied to the output terminal (all of the anodes of the diodes) and the entire matrix is addressed to complete a first subframe. The data from data drivers 25 includes a digital signal that turns ON each pixel (completes a circuit from the cathode of the diode to ground) that requires a first level or shade of gray. A second step of voltage (e.g. I=2) is applied to the output terminal (all of the anodes of the diodes) and the entire matrix is addressed to complete a second subframe. This procedure is continued until all m of the subframes are completed, completing a frame.

A timing circuit 35 is attached to data drivers 25, shift register 27 and voltage source 30 to ensure proper synchronization of the subframes and frames. Also, in instances where the data is communicated through a wireless communication system (e.g. radio, cellular telephone, etc.) timing circuit 35 is synchronized to the incoming data. Thus, by subdividing a frame into m subframes and properly synchronizing voltage source 30 to the scan and data drivers, an m-bit gray scale is achieved using simple digital data drivers.

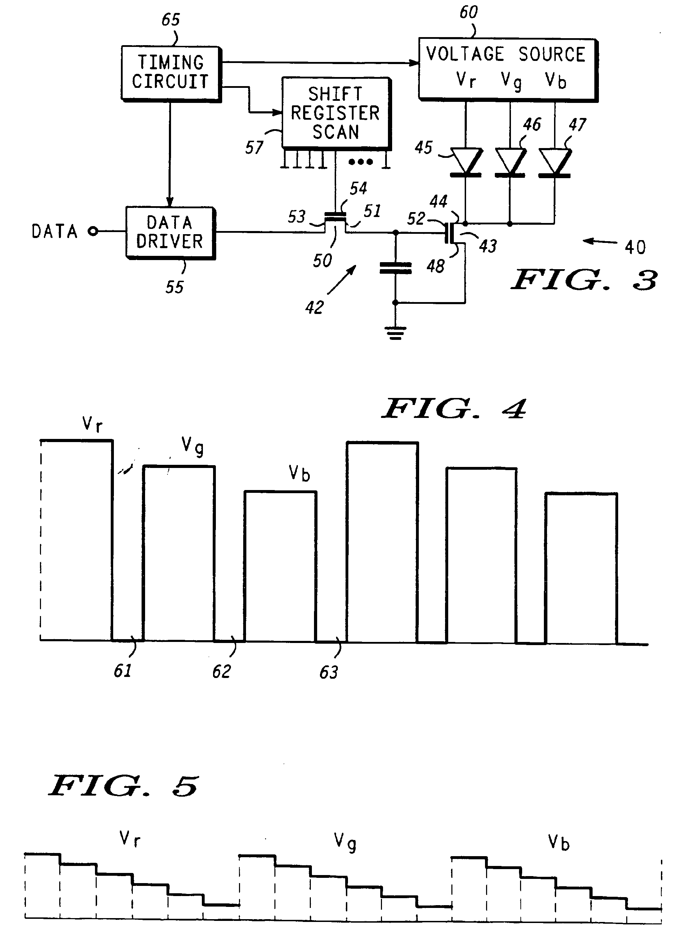

Referring now to FIG. 3, a simplified block/schematic diagram is illustrated showing another embodiment of an active driven light emitting diode matrix, which is utilized to produce full color images. For simplicity of this description, a single pixel 40 is illustrated but it will be understood that pixel 40 is simply one pixel in a two dimensional array or matrix including rows and columns of pixels. Pixel 40, and each other pixel in the matrix, has a semiconductor switch 42 attached thereto, making the matrix an active matrix.

In this specific embodiment switch 42 includes a first transistor 43 having a current carrying electrode 44 connected in common to the cathodes of three light emitting diodes 45, 46, and 47 and a current carrying electrode 48 connected to a common return, such as ground or the like. Switch 42 further includes a second transistor 50 having a current carrying terminal 51 connected to a gate or control terminal 52 of transistor 43. A second current carrying terminal 53 of transistor 50 serves as a data input and a gate or control terminal 54 serves as an input for scan signals. In this specific embodiment, light emitting diodes 45, 46, and 47 and switch 42 form a pixel. While transistors 43 and 50 are illustrated as n-type devices, it will be understood by those skilled in the art that diodes 45, 46, and 47 could be reversed and p-type devices could be used in switch 42, if desired.

In this preferred embodiment, light emitting diodes 45, 46, and 47 are organic light emitting diodes designed to produce red, green and blue light, respectively, when energized. Pixel 40 is addressed by supplying a scan signal to control terminal 54 of transistor 50 and a data signal to current terminal 53. Depending upon the data signal, when transistor 43 is activated a current path is completed between all three cathodes of light emitting diodes 45, 46, and 47 and the common return, or ground. Each current carrying terminal 53 for each switch 42 in each pixel in a column are connected together and to a data driver 55. As an example, in a typical matrix containing 640 columns by 480 rows of pixels, there are 640 data drivers 55. Data is supplied to a data input of each data driver 55, which data may be, for example, received from a wireless communication or from some data bank or storage device and may represent alpha-numeric and/or graphic information.

Control terminal 54 of each switch 42 in a row of pixels are connected together and to a circuit for supplying scan signals thereto. In the structure of FIG. 3, for purposes of this explanation, a shift register 57 is provided to supply the scan signals. Shift register 57 has a separate output for each row in the matrix (e.g. 480 outputs) and sequentially supplies a scan signal on each output in turn. Thus rows 1 through 480 of the matrix are sequentially supplied with a scan signal. As is understood in the art, a scan signal is applied to each row for a sufficient time to allow all of the data drivers to be activated so that each pixel in the row being scanned is addressed. A scan signal is then applied to the next row and all of the data drivers are activated, etc. Therefore, each pixel in the matrix is addressed by the combination of data drivers 55 and shift register 57.

A voltage source 60 is provided which is constructed to repetitiously supply voltage to each of three outputs, designated Vr, Vg, and Vb, as illustrated in FIG. 4. The anodes of the light emitting diodes 45 in all of the pixels in the matrix (e.g. 480 x 640 = 307,200) are connected together and to output terminal Vr of voltage source 60. The anodes of the light emitting diodes 46 in all of the pixels in the matrix are connected together and to output terminal Vg of voltage source 60. The anodes of the light emitting diodes 47 in all of the pixels in the matrix are connected together and to output terminal Vb of voltage source 60.

In the operation, a first voltage is applied to the output terminal Vr and the entire matrix is addressed to complete a first subframe. Generally, the entire matrix (all pixels), can be addressed in several well known addressing schemes, for example, by sequencing through the rows, one through n, and supplying data to all of the columns simultaneously in parallel as each row is addressed. Whatever addressing scheme is used, the result is to provide each pixel in the array with a scan and a data signal. Data drivers 55 could be analog drivers that turn switches 42 on for a predetermined amplitude or time of current flow through one of diodes 45, 46, or 47 to achieve the amount of each color desired in each pixel. A second voltage Vg is applied to the output terminal Vg and the entire matrix is addressed to complete a second subframe. A third voltage Vb is applied to the output terminal Vb and the entire matrix is addressed to complete a third subframe. The three subframes form a complete frame and the procedure is repeated at a rate of approximately 60 frames per second.

Referring again to FIG. 4, each of the voltages Vr, Vg, and Vb has associated therewith a blanking pulse 61, 62, and 63, respectively. The blanking pulses are provided before each subframe to allow for the transfer of data into the storage capacitor. Thus, the next subframe begins with a proper value of data in the storage capacitor when the diode is turned on. It may be desirable (e.g. in the cases of figures 2 and 5) to provide blanking pulses between each subframe and sub-subframe and, in some applications the blanking pulses may actually include a reverse bias (a negative voltage) to improve the reliability of the diode and especially organic light emitting diodes. The negative voltage ensures the complete removal of any charge build-up that may occur in the various circuits.

A timing circuit 65 is attached to data drivers 55, shift register 57 and voltage source 60 to ensure proper synchronization of the subframes and frames. Also, in instances where the data is communicated through a wireless communication system (e.g. radio, cellular telephone, etc.) timing circuit 65 is synchronized to the incoming data. Thus, by subdividing a frame into a plurality of subframes equal to the number of colors being used and properly synchronizing voltage source 60 to the scan and data drivers, a color image is achieved. It will of course be understood that diodes which generate light of two different colors can be used for generating colored images which are less than full color. Also, in some applications it may be desirable for different portions of an image to be a different color.

Thus, while a more complicated analog driver could be used, the number of active matrix elements (i.e. two FETs and a capacitor) and the number of data drivers is reduced by a factor of three for a full color display. This is a substantial reduction in the size and cost of the matrix and the cost of the drivers.

Referring to FIG. 5, a multi-step voltage waveform is illustrated for a different embodiment of an active driven light emitting diode matrix in accordance with the present invention. The waveform of FIG. 5 will be explained in conjunction with the structure of FIG. 3, which again is utilized to produce full color images. In this modified embodiment, data drivers 55 are relatively simple digital drivers, rather than the previously described analog drivers, for reasons that will be apparent presently.

In the multi-step voltage waveform of FIG. 5, one complete frame is illustrated. Each frame is divided into three subframes Vr, Vg, and Vb and each subframe is divided into m multi-steps of voltage or sub-subframes. As described previously, the multi-step subframe Vr is applied to the Vr output of voltage source 60 and the entire matrix is addressed for each of the m steps. This procedure is continued until all m of the sub-subframes are completed, completing a subframe. Voltage source 60 is then switched so that the multi-step subframe Vg is applied to the Vg output. The entire matrix is again addressed for each of the m steps and the procedure is continued until all m of the sub-subframes are completed, completing a second subframe. When the second subframe is completed, voltage source 60 is switched so that the multi-step subframe Vb is applied to the Vb output. The entire matrix is again addressed for each of the m steps and the procedure is continued until all m of the sub-subframes are completed, completing a third subframe. The entire procedure is then repeated.

Because the multi-step voltage waveforms provide different intensities of each of the various colors, the data drivers, in this embodiment, are simple digital drivers used to turn on switch 42 for a specific time. Thus, the number of active matrix elements (i.e. two FETs and a capacitor) and the number of data drivers is reduced by a factor of three for a full color display and, in addition, the data drivers are greatly simplified. This is a substantial reduction in the cost and number of the data drivers and in the size and cost of the matrix.

Accordingly, displays, and especially color displays, with simpler and/or fewer data drivers have been disclosed. In particular, relatively simple digital drivers can be used instead of much more complicated and expensive analog drivers, to greatly reduce the cost of displays. In addition, the disclosed displays incorporate fewer components in the active matrix so that not only are the data drivers reduced in number and simplified but the matrix is also simplified. Further, because the active components in a matrix for a full color display are reduced by one third, the matrix is easier to manufacture and can be made smaller.

While we have shown and described specific embodiments of the present invention, further modifications and improvements will occur to those skilled in the art.

## Claims

1. Active drive apparatus for a matrix of light emitting devices comprising;
a voltage source (30, 60);
a matrix including a plurality of rows of pixels (10 and 12, 42 and 45, 46, 47) and a plurality of columns of pixels (10 and 12, 42 and 45, 46, 47), each pixel comprising at least one light emitting device (10, 45, 46, 47), each of said one or more light emitting devices having a first contact connected to the voltage source (30, 60) and a second contact;
a timing circuitry (35, 65);
a shift register (27, 57);
column driver circuit (25, 55);
a plurality of semiconductor switches (12, 42), each associated with each pixel, each semiconductor switch (12, 42) having a first current carrying terminal (14, 44) connected to the second contact of the at least one light emitting device (10, 45, 46, 47) of the associated pixel, and a second current carrying terminal (15, 48) connected to a common terminal, each semiconductor switch (12, 42) further having first and second activating input terminals (21, 22, 53, 54), and each semiconductor switch (12, 42) being constructed to complete a circuit between the first and second current carrying terminals (13, 15, 43, 48) only when activating signals are supplied to both of the first and second activating input terminals (21, 22, 53, 54);
wherein said timing circuitry (35, 65) is connected to the column driver circuits (25, 55) and to the shift register (27, 57), the timing circuit (35, 65) being constructed to control the shift register (27, 57) to provide an activating signal to each row in sequence and to control each column driver circuit (25, 55) to provide an activating signal to each column in sequence for each activating signal applied to a row, each activation of all of the rows in the matrix being defined as a sub-frame
**characterized in that**
said timing circuitry (35, 65) is connected to the voltage source (30, 60) and is adapted to activate said voltage source;
said voltage source (30, 60) is constructed to repetitiously supply a multi-step voltage waveform (Vs, Vr, V, Vb) when activated; and **in that**
the timing circuit (35, 65) is further constructed to control the voltage source (30, 60) to supply a next sequential step of the multi-step voltage waveform (Vs, V, V91 Vb) each time a sub-frame is completed, a frame being completed when all of the multi- step voltages of the waveform are supplied.

2. Active drive apparatus for a matrix of light emitting devices as claimed in claim 1 further **characterized in that** the multi-step voltage waveform (Vₛ, Vᵣ, V_{g}, V_{b}) which the voltage source (30, 60) is constructed to repetitiously supply includes a plurality of ascending steps of voltage, each representing a level of a multi-bit gray scale.

3. Active drive apparatus for a matrix of light emitting devices as claimed in claim 1 further **characterized in that** the light emitting devices (10, 45, 46, 47) are organic light emitting diodes.

4. Active drive apparatus for a matrix of light emitting devices as claimed in claim 1 further **characterized in that** each of the plurality of semiconductor switches (12, 42) includes a first transistor (13, 43) with current carrying electrodes (14, 15, 44, 48) forming the first and second current carrying terminals (14, 15, 44, 48) of the semiconductor switch (12, 42), and a control electrode (20, 52).

5. Active drive apparatus for a matrix of light emitting devices as claimed in claim 4 further **characterized in that** each of the plurality of semiconductor switches (12, 42) further includes a second transistor (18, 50) with a first current carrying electrode (19, 51) connected to the control electrode (20, 52) of the first transistor (13, 43), a second current carrying electrode (21, 53) forming the first activating input terminal (21, 53) of the semiconductor switch (12, 42), and a control terminal (22, 54) forming the second activating input terminal (22, 54) of the semiconductor switch (12, 42).

6. Active drive apparatus for a matrix of light emitting devices as claimed in claim 1 further **characterized in that** all of the first activating terminals (21, 53) of each semiconductor switch (12, 42) associated with the light emitting devices (10, 45, 46, 47) in each specific column of light emitting devices (10, 45, 46, 47) are connected together and to a column driver circuit (25, 55).

7. Active drive apparatus for a matrix of light emitting devices as claimed in claim 6 further **characterized in that** each of the column driver circuits (25, 55) is a digital driver.

8. Active drive apparatus for a matrix of light emitting devices as claimed in claim 6 further **characterized in that** all of the second activating terminals (22, 54) of each semiconductor switch (12, 42) associated with the light emitting device (10, 45, 46, 47) in each specific row of light emitting devices (10, 45, 46, 47) are connected together and to an output of the shift register (27, 57).

9. A method of driving a matrix of light emitting devices comprising the steps of:
addressing each pixel (10, 40) of a matrix having a plurality of rows of pixels (10, 40) and a plurality of columns of pixels (10, 40), each pixel (10, 40) including at least a first light emitting device having a first contact connected to a first output of a voltage source (30, 60) and a second contact, by supplying scan and image data (27, 57, 25, 55) activating signals to each of the pixels (10, 40) of the matrix, the image data (25, 55) activating signals being used to determine when a pixel (10, 40) is activated by completing a current path from the second contact (14, 44) of each pixel (10, 40) to a second output (15, 48) of the voltage source (30, 60),
**characterized by** the steps of:
activating a voltage source (30, 60) constructed to repetitiously supply a multi-step voltage waveform (Vₛ, Vᵣ, V_{g}, V_{b}) when activated to repetitiously supply multi-step waveforms (Vₛ, Vᵣ, V_{g}, V_{b}) of voltage and sequentially supply each step of each of the multi-step voltage waveforms (Vₛ, Vᵣ, V_{g}, V_{b}) to the pixels (10, 40), and addressing each of the pixels (10, 40) in the matrix for each step supplied, wherein each activation or addressing of all of the pixels (10, 45, 46, 47) in the matrix being a sub-frame;
controlling the voltage source (30, 60) with a timing circuit (35, 65) to supply a next sequential step of the multi-step voltage waveform (Vₛ, Vᵣ, V_{g}, V_{b}) each time a sub-frame is completed, a frame being completed when all of the multi-step voltages of the waveform are supplied.

## Patentansprüche

1. Aktives Antriebsgerät für eine Matrix lichtemittierender Vorrichtungen, welches Folgendes aufweist:
eine Spannungsquelle (30, 60)
eine Matrix, welche eine Vielzahl von Reihen von Pixeln oder Bildelementen (10 und 12, 42 und 45, 46, 47) sowie eine Vielzahl von Spalten von Pixeln oder Bildelementen (10 und 12, 42 und 45, 46, 47) aufweist, wobei jedes Pixel oder Bildelement mindestens eine lichtemittierende Vorrichtung (10, 45, 46, 47) aufweist, wobei die eine oder jede der Mehrzahl lichtemittierender Vorrichtungen einen ersten Kontakt, welcher mit der Spannungsquelle (30, 60) verbunden ist, sowie einen zweiten Kontakt aufweist;
eine Zeitsteuerungs-Schaltkreisanordnung (35, 65);
ein Schieberegister (27, 57);
einen Spalten-Treiberschaltkreis (25, 55);
eine Vielzahl von Halbleiterschaltern (12, 42), welche jeweils jedem Pixel oder Bildelement zugehörig sind, wobei jeder Halbleiterschalter (12, 42) einen ersten stromführenden Anschluss (14, 44), der mit dem zweiten Kontakt der mindestens einen lichtemittierenden Vorrichtung (10, 45, 46, 47) des zugehörigen Pixels oder Bildelements verbunden ist, sowie einen zweiten stromführenden Anschluss (15, 48) aufweist, der mit einem herkömmlichen Anschluss verbunden ist, wobei jeder Halbleiterschalter (12, 42) des Weiteren erste und zweite Aktivierungs-Eingangsanschlüsse (21, 22, 53, 54) aufweist, und jeder Halbleiterschalter (12, 42) derart konstruiert oder aufgebaut ist, dass er einen Schaltkreis zwischen den ersten und zweiten stromführenden Anschlüssen (13, 15, 43, 48) nur dann vervollständigt, wenn Aktivierungssignale an sowohl die ersten als auch die zweiten Aktivierungs-Eingangsanschlüsse (21, 22, 53, 54) geliefert werden;
wobei die Zeitsteuerungs-Schaltkreisanordnung (35, 65) mit den Spalten-Treiberschaltkreisen (25, 55) sowie dem Schieberegister (27, 57) verbunden ist, wobei die Zeitsteuerungs-schaltung (35, 65) derart konstruiert ist, dass sie das Schiebe- register (27, 57) zur Bereitstellung eines Aktivierungssignals für jede Reihe der Reihe nach steuert und dass sie jeden Spalten-Treiberschaltkreis (25, 55) zur Bereitstellung eines-Aktivierungssignals für jede Spalte der Reihe nach für jedes an eine Reihe angelegte Aktivierungsignal bereitstellt, wobei jede Aktivierung aller Reihen in der Matrix als ein Subframe definiert wird,
**dadurch gekennzeichnet, dass**
die Zeitsteuerungs-Schaltkreisanordnung (35, 65) mit der Spannungsquelle (30, 60) verbunden ist und derart ausgelegt ist, dass sie die Spannungsquelle aktiviert oder antreibt;
die Spannungsquelle (30, 60) derart konstruiert ist, dass sie wiederholt eine mehrstufige Spannungswellenform (Vₛ, Vᵣ, V_{g}, V_{b}b) bei Aktivierung bereitstellt; und dass
die Zeitsteuerungsschaltung (35, 65) des Weiteren so ausgelegt ist, dass sie die Spannungsquelle (30, 60) derart steuert, dass diese eine nächste nachfolgende Stufe der mehrstufigen Spannungswellenform (Vₛ Vᵣ, V_{g}, V_{b}) jedesmal bei Vervollständigung eines Subframes bereitstellt, wobei ein Frame vollständig ist, wenn alle mehrstufigen Spannungen der Wellenform bereitgestellt worden sind.

2. Aktives Antriebsgerät für eine Matrix lichtemittierender Vorrichtungen nach Anspruch 1, welches des Weiteren **dadurch gekennzeichnet ist, dass** die mehrstufige Spannungswellenform (Vₛ, Vᵣ, V_{g}, V_{b}), zu deren wiederholten Bereitstellung die Spannungsquelle (30, 60) konstruiert ist, eine Vielzahl ansteigender Spannungs- stufen aufweist, wobei jede Spannungsstufe einen Pegel einer Mehrbit-Grauskala darstellt.

3. Aktives Antriebsgerät für eine Matrix lichtemittierender Vorrichtungen nach Anspruch 1, welches des Weiteren **dadurch gekennzeichnet ist, dass** die lichtemittierenden Vorrichtungen (10, 45, 46, 47) organische lichtemittierende Dioden sind.

4. Aktives Antriebsgerät für eine Matrix lichtemittierender Vorrichtungen nach Anspruch 1, welches des Weiteren **dadurch gekennzeichnet ist, dass** jeder aus der Vielzahl von Halbleiterschaltern (12, 42) einen ersten Transistor (13, 43) mit stromführenden Elektroden (14, 15, 44, 48), welche die ersten und zweiten stromführenden Anschlüsse (14, 15, 44, 48) des Halbleiter-Schalters (12, 42) bilden, sowie eine Steuerelektrode (20, 52) aufweist.

5. Aktives Antriebsgerät für eine Matrix lichtemittierender Vorrichtungen nach Anspruch 4, welches des Weiteren **dadurch gekennzeichnet ist, dass** jeder aus der Vielzahl von Halbleiterschaltern (12, 42) des Weiteren einen zweiten Transistor (18, 50) mit einer ersten stromführenden Elektrode (19, 51), welche mit der Steuerelektrode (20, 52) des ersten Transistors (13, 43) verbunden ist, eine zweite stromführende Elektrode (21, 53), welche den ersten Aktivierungs-Eingangsanschluss (21, 53) des Halbleiterschalters (12, 42) bildet, und einen Steueranschluss (22, 54), welcher den zweiten Aktivierungs-Eingangsanschluss (22, 54) des Halbleiterschalters (12, 42) bildet, aufweist.

6. Aktives Antriebsgerät für eine Matrix lichtemittierender Vorrichtungen nach Anspruch 1, welches des Weiteren **dadurch gekennzeichnet ist, dass** alle ersten Aktivierungsanschlüsse (21, 53) eines jeden Halbleiterschalters (12, 42), welche den lichtemittierenden Vorrichtungen (10, 45, 46, 47) in jeder spezifischen Spalte der lichtemittierenden Vorrichtungen (10, 45, 46, 47) zugehörig sind, miteinander und mit einem Spalten-Treiberschaltkreis (25, 55) verbunden sind.

7. Aktives Antriebsgerät für eine Matrix lichtemittierender Vorrichtungen nach Anspruch 6, welches des Weiteren **dadurch gekennzeichnet ist, dass** jeder der Spalten-Treiberschaltkreise (25, 55) ein digitaler Treiber ist.

8. Aktives Antriebsgerät für eine Matrix lichtemittierender Vorrichtungen nach Anspruch 6, welches des Weiteren **dadurch gekennzeichnet ist, dass** alle zweiten Aktivierungsanschlüsse (22, 54) eines jeden Halbleiterschalters (12, 42), welche der licht- emittierenden Vorrichtung (10, 45, 46, 47) in jeder spezifischen Reihe der lichtemittierenden Vorrichtungen (10, 45, 46, 47) zugehörig sind, miteinander und mit einem Ausgang des Schieberegisters (27, 57) verbunden sind.

9. Verfahren zum Antrieb einer Matrix lichtemittierender Vorrichtungen, wobei das Verfahren die folgenden Schritte aufweist:
Adressierung eines jeden Pixels oder Bildelements (10, 40) einer Matrix, welche eine Vielzahl von Reihen von Pixeln oder Bildelementen (10, 40) sowie eine Vielzahl von Spalten von Pixeln oder Bildelementen (10, 40) aufweist, wobei jedes Pixel oder Bildelement (10, 40) mindestens eine erste lichtemittierende Vorrichtung mit einem ersten Kontakt, der mit einem ersten Ausgang einer Spannungsquelle (30, 60) verbunden ist, sowie mit einem zweiten Kontakt aufweist, indem Abtast- und Bilddaten(27, 57, 25, 55)-Aktivierungssignale für jedes Pixel oder Bildelement (10, 40) der Matrix bereitgestellt werden,
wobei die Bilddaten(25, 55)-Aktivierungssignale zur Bestimmung verwendet werden, wann ein Pixel oder Bildelement (10, 40) aktiviert ist, indem ein Strompfad von dem zweiten Kontakt (14, 44) eines jeden Pixels oder Bildelements (10, 40) zu einem zweiten Ausgang (15, 48) der Spannungsquelle (30, 60) vervollständigt wird,
wobei das Verfahren durch die folgenden Schritte **gekennzeichnet** ist:
Aktivierung einer Spannungsquelle (30, 60), welche bei Aktivierung für die wiederholte Bereitstellung einer mehrstufigen Spannungswellenform (Vₛ, Vᵣ, V_{g}, V_{b}) konstruiert ist, um mehrstufige Wellenformen (Vₛ, Vᵣ, V_{g}, V_{b}) von Spannung wiederholt bereitzustellen und jede Stufe aller mehrstufigen Spannungswellenformen (Vₛ, Vᵣ, V_{g}, V_{b}) für die Pixel oder Bildelemente (10, 40) der Reihe nach bereitzustellen, und Adressierung eines jeden Pixels oder Bildelements (10, 40) in der Matrix für jede bereitgestellte Stufe, wobei jede Aktivierung oder Adressierung aller Pixel oder Bildelemente (10, 45, 46, 47) in der Matrix ein Subframe ist; und
Steuern der Spannungsquelle (30, 60) mit Hilfe einer Zeitsteuerungsschaltung (35, 65) zur Bereitstellung einer nächsten nachfolgenden Stufe der mehrstufigen Spannungswellenform (Vₛ Vᵣ, V_{g}, V_{b}) jedesmal bei Vervollständigung eines Subframes,
wobei ein Frame vollständig ist, wenn alle mehrstufigen Spannungen der Wellenform bereitgestellt worden sind.

## Revendications

1. Appareil d'entraînement actif destiné à une matrice de dispositifs électroluminescents comprenant:
une source de tension (30, 60);
une matrice comprenant une pluralité de rangées de pixels (10 et 12, 42 et 45, 46, 47) et une pluralité de colonnes de pixels (10 et 12, 42 et 45, 46, 47), chaque pixel comprenant au moins un dispositif électroluminescent (10, 45, 46, 47) chacun dudit ou desdits dispositif(s) électroluminescent(s) ayant un premier contact relié à la source de tension (30, 60) et un second contact;
des circuits de synchronisation (35, 65);
un registre de décalage (27, 57);
un circuit d'entraînement de colonne (25, 55);
une pluralité de commutateurs à semi-conducteurs (12, 42), chacun associés à chaque pixel, chaque commutateur à semi-conducteurs (12, 42) ayant une première borne de transport de courant (14, 44) reliée au second contact du dispositif électroluminescent au moins (10, 45, 46, 47) du pixel associé, et une seconde borne de transport de courant (15, 48) reliée à une borne commune, chaque commutateur à semi-conducteurs (12, 42) ayant en outre une première et une seconde bornes d'entrée d'activation (21, 22, 53, 54), et chaque commutateur à semi-conducteurs (12, 42) étant construit afin de réaliser un circuit entre la première et la seconde bornes de transport de courant (13, 15, 43, 48) uniquement lorsque des signaux d'activation sont fournis à la première et à la seconde bornes d'entrée d'activation (21, 22, 53, 54);
dans lequel lesdits circuit de synchronisation (35, 65) sont reliés aux circuits d'entraînement de colonnes (25, 55) et au registre de décalage (27, 57), le circuit de synchronisation (35, 65) étant construit afin de contrôler le registre de décalage (57, 57) de façon à fournir un signal d'activation à chaque rangée en séquence et afin de contrôler chaque circuit d'entraînement de colonne (25, 55) de façon à fournir un signal d'activation à chaque colonne en séquence pour chaque signal d'activation appliqué à une rangée, chaque activation de l'ensemble des rangées de la matrice étant définie comme étant une sous-trame,
**caractérisé en ce que**
lesdits circuits de synchronisation (35, 65) sont reliés à la source de tension (30, 60) et sont adaptés afin d'activer ladite source de tension;
ladite source de tension (30, 60) est construite afin de fournir de manière répétée une forme d'onde de tension à plusieurs étages (Vs, Vr, Vb) lorsqu'elle est activée; et **en ce que**
le circuit de synchronisation (35, 65) est en outre construit afin de contrôler la source de tension (30, 60) de façon à fournir un étage séquentiel suivant à la forme d'onde de tension à étages multiples (Vs, V, V91 Vb) à chaque fois qu'une sous-trame est réalisée, une trame étant réalisée lorsque l'ensemble des tensions à étages multiples de la forme d'onde est fourni.

2. Appareil d'entraînement actif destiné à une matrice de dispositifs électroluminescents selon la revendication 1, **caractérisé en outre en ce que** la forme d'onde de tension à étages multiples (Vₛ, Vᵣ, V_{g}, V_{b}) que la source de tension (30, 60) doit fournir de manière répétée comprend une pluralité d'étages ascendants de tension, représentant chacun un niveau d'une échelle de gris à plusieurs bits.

3. Appareil d'entraînement actif destiné à une matrice de dispositifs électroluminescents selon la revendication 1, **caractérisé en outre en ce que** les dispositifs électroluminescents (10, 45, 46, 47) sont des diodes électroluminescentes organiques.

4. Appareil d'entraînement actif destiné à une matrice de dispositifs électroluminescents selon la revendication 1, **caractérisé en outre en ce que** chacun de la pluralité de commutateurs à semi-conducteurs (12, 42) comprend un premier transistor (13, 43) ayant des électrodes de transport de courant (14, 15, 44, 48) formant la première et la seconde bornes de transport de courant (14, 15, 44, 48) du commutateur à semi-conducteurs (12, 42), et une électrode de commande (20, 52).

5. Appareil d'entraînement actif destiné à une matrice de dispositifs électroluminescents selon la revendication 4, **caractérisé en outre en ce que** chacun de la pluralité de commutateurs à semi-conducteurs (12, 42) comprend en outre un second transistor (18, 50) ayant une première électrode de transport de courant (19, 51) reliée à l'électrode de commande (20, 52) du premier transistor (13, 43), une seconde électrode de transport de courant (21, 53) formant la première borne d'entrée d'activation (21, 53) du commutateur à semi-conducteurs (12, 42), et une borne de commande (22, 54) formant la seconde borne d'entrée d'activation (22, 54) du commutateur à semi-conducteurs (12, 42).

6. Appareil d'entraînement actif destiné à une matrice de dispositifs électroluminescents selon la revendication 1, **caractérisé en outre en ce que** toutes les premières bornes d'activation (21, 53) de chaque commutateur à semi-conducteurs (12, 42) associé aux dispositifs électroluminescents (10, 45, 46, 47) dans chaque colonne spécifique de dispositifs électroluminescents (10, 45, 46, 47) sont reliées ensemble et à un circuit d'entraînement de colonne (25, 55).

7. Appareil d'entraînement actif destiné à une matrice de dispositifs électroluminescents selon la revendication 6, **caractérisé en outre en ce que** chacun des circuits d'entraînement de colonne (25, 55) est un dispositif d'entraînement numérique.

8. Appareil d'entraînement actif destiné à une matrice de dispositifs électroluminescents selon la revendication 6, **caractérisé en outre en ce que** toutes les secondes bornes d'activation (22, 54) de chaque commutateur à semi-conducteurs (12, 42) associé au dispositif électroluminescent (10, 45, 46, 47) dans chaque rangée spécifique de dispositifs électroluminescents (10, 45, 46, 47) sont reliées ensemble et à une sortie du registre de décalage (27, 57).

9. Procédé d'entraînement d'une matrice de dispositifs électroluminescents comprenant les étapes consistant à:
adresser chaque pixel (10, 40) d'une matrice ayant une pluralité de rangées de pixels (10, 40) et une pluralité de colonnes de pixels (10, 40), chaque pixel (10, 40) comprenant au moins un premier dispositif électroluminescent ayant un premier contact relié à une première sortie d'une source de tension (30, 60) et un second contact, en fournissant des signaux d'activation de données de balayage et d'image (27, 57, 25, 55) à chacun des pixels (10, 40) de la matrice, les signaux d'activation de données d'image (25, 55) étant utilisés afin de déterminer le moment auquel un pixel (10, 40) est activé en réalisant un trajet de courant entre le second contact (14, 44) de chaque pixel (10, 40) et une seconde sortie (15, 48) de la source dé tension (30, 60),
**caractérisé par** les étapes consistant à:
activer une source de tension (30, 60) construite afin de fournir de manière répétée une forme d'onde de tension à étages multiples (Vₛ, Vᵣ, V_{g}, V_{b}) lorsqu'elle est activée, de façon à fournir de manière répétée des formes d'onde de tension à étages multiples (Vₛ, Vᵣ, V_{g}, V_{b}) et à fournir séquentiellement chaque étage de chacune des formes d'onde de tension à étages multiples (Vₛ, Vᵣ, V_{g}, V_{b}) aux pixels (10, 40), et adresser chacun des pixels (10, 40) de la matrice pour chaque étage fourni, où chaque activation ou adressage de l'ensemble des pixels (10, 45, 46, 47) de la matrice est une sous-trame;
contrôler la source de tension (30, 60) avec un circuit de synchronisation (35, 65) afin de fournir un étage séquentiel suivant de la forme d'onde de tension à étages multiples (Vₛ, Vᵣ, V_{g}, V_{b}) à chaque fois qu'une sous-trame est réalisée, une trame étant réalisée lorsque l'ensemble des tensions à étages multiples de la forme d'onde a été fourni.
